# EUROPEAN PATENT APPLICATION

(11) **EP 4 797 893 A1**
(43) Date of publication of application: **26.08.2026**
(21) Application number: 24890018.5
(22) Date of filing: 20.05.2024
(51) Int. Cl.: H05K 7/20

(54) **PHOTOVOLTAIC INVERTER AND PHOTOVOLTAIC POWER GENERATION SYSTEM**

(30) Priority: 15.11.2023 CN 202311524620
(71) Applicant: Huawei Digital Power Technologies Co., Ltd., Shenzhen, Guangdong 518043 (CN)
(72) Inventor: SUN, Faming, Shenzhen, Guangdong 518043 (CN); LI, Quanming, Shenzhen, Guangdong 518043 (CN); YANG, Zhibing, Shenzhen, Guangdong 518043 (CN)
(74) Representative: Gill Jennings & Every LLP
(86) International application number: PCT/CN2024/094237
(87) International publication number: WO 2025/102647

(57) **Abstract**

This application provides a photovoltaic inverter and a photovoltaic power generation system. The photovoltaic inverter has good effect. The photovoltaic inverter includes at least one power semiconductor device, a heat sink, and a lower box body and an upper box body that are arranged in a first direction. The lower box body is configured to accommodate the at least one power semiconductor device. The heat sink includes two condensers and at least one evaporator. The evaporator is configured to: be connected to the condenser through a two-phase pipeline, be in contact with and connected to an outer wall of the lower box body, and be connected to the power semiconductor device in a thermally conductive manner. The upper box body includes a middle separator and two air vents arranged opposite to each other in a second direction. The middle separator is in a stepped structure in the second direction. The middle separator is configured to separate a cavity of the upper box body into two sub-cavities, each sub-cavity is configured to accommodate one condenser, and the two condensers are spaced from each other in the second direction.

## Description

This application claims priority to Chinese Patent Application No. 202311524620.0, filed with the China National Intellectual Property Administration on November 15, 2023 and entitled "PHOTOVOLTAIC INVERTER AND PHOTOVOLTAIC POWER GENERATION SYSTEM", which is incorporated herein by reference in its entirety.

### TECHNICAL FIELD

This application relates to the field of photovoltaic technologies, and specifically, to a photovoltaic inverter and a photovoltaic power generation system.

### BACKGROUND

In a photovoltaic power generation system, a photovoltaic inverter may convert an input direct current into an alternating current. The direct current is also referred to as a direct current, or DC for short. The alternating current is also referred to as an alternating current, or AC for short. Generally, a power transistor is disposed in the photovoltaic inverter. As the power transistor delivers relatively high output power, it generates substantial heat.

However, the existing photovoltaic inverter has poor heat dissipation effect, which affects a service life of the power transistor in the photovoltaic inverter, and further affects a service life of the photovoltaic inverter.

### SUMMARY

This application provides a photovoltaic inverter and a photovoltaic power generation system, to improve heat dissipation effect of the photovoltaic inverter and prolong a service life of the photovoltaic inverter.

According to a first aspect, a photovoltaic inverter is provided. The photovoltaic inverter includes at least one power semiconductor device, a heat sink, an upper box body, and a lower box body. The lower box body is configured to accommodate the power semiconductor device. The heat sink includes two condensers and at least one evaporator. The evaporator is configured to: be connected to the condenser through a two-phase pipeline, be in contact with and connected to an outer wall of the lower box body, and be connected to the power semiconductor device in a thermally conductive manner. The upper box body and the lower box body are arranged in a first direction. The upper box body includes a middle separator and two air vents arranged opposite to each other in a second direction. The middle separator is in a stepped structure in the second direction. The middle separator is configured to separate a cavity of the upper box body into two sub-cavities, each sub-cavity is configured to accommodate one condenser, and the two condensers are spaced from each other in the second direction.

According to the photovoltaic inverter provided in this embodiment of this application, a refrigerant in the evaporator can absorb heat generated by the power semiconductor device in the lower box body and is evaporated into a gaseous refrigerant, and the gaseous refrigerant may enter each condenser in the upper box body through a gas pipeline in the two-phase pipeline connected to each condenser. External air flows into each separate sub-cavity of the upper box body through one air vent of the upper box body, takes away a part of heat of each condenser in a process of flowing in each separate sub-cavity, and flows out of each separate sub-cavity through the other air vent of the upper box body. In this way, the gaseous refrigerant in the condenser in the upper box body is cooled and condensed into a liquid refrigerant. Under action of gravity, each condenser in the upper box body flows back to the evaporator through a liquid pipeline in the two-phase pipeline, to dissipate heat for the power semiconductor device of the photovoltaic inverter.

Because the condenser and the evaporator are disposed in the first direction, the refrigerant in the evaporator can be vaporized and then enter the condenser without being driven by a pump or another power device, and the refrigerant condensed into a liquid state by the condenser flows back to the evaporator under the action of gravity. In this way, efficient circulation of the refrigerant between the evaporator and the evaporator is implemented. In addition, because the middle separator is of the stepped structure in the second direction, each separate sub-cavity in the upper box body is also of a stepped structure in the second direction. In addition, each condenser is disposed in a separate sub-cavity, and the two condensers are spaced from each other in the second direction. In this way, not only heat dissipated by each sub-cavity does not affect each other, but also a thermal cascading phenomenon can be avoided. In addition, when a size of the upper box body is fixed, sufficient condensation area is ensured. Further, heat dissipation effect of the photovoltaic inverter is improved, and a service life of the photovoltaic inverter is prolonged.

In addition, on a premise that the size of the upper box body is fixed, the middle separator of the stepped structure is disposed in the upper box body, so that heat dissipated by each sub-cavity can be isolated, and a sufficient condensation area is ensured. This simplifies a processing process and an assembly process of the photovoltaic inverter, and reduces production costs of the photovoltaic inverter.

In an implementation, the middle separator includes three substrates. Two separators are spaced from each other in the first direction, and projections of the two separators in the first direction do not overlap; or two separators are spaced from each other in a third direction, and projections of the two separators in the third direction do not overlap. Another substrate is configured to be connected to the two substrates. In an arrangement direction of the two substrates, a projection of each substrate overlaps a projection of one condenser.

The two substrates are spaced from each other in the first direction, and projections of the two substrates in the first direction do not overlap. In other words, the middle separator separates the cavity of the upper box body into two sub-cavities that are arranged opposite to each other in the first direction. In this way, external air flows into the two sub-cavities that are arranged opposite to each other in the first direction through one air vent of the upper box body, takes away a part of heat of each condenser in a process of flowing in each separate sub-cavity, and flows out of each separate sub-cavity through the other air vent of the upper box body. In this way, the gaseous refrigerant in the condenser in the upper box body is cooled and condensed into a liquid refrigerant. Under action of gravity, each condenser in the upper box body flows back to the evaporator through a liquid pipeline in the two-phase pipeline, to dissipate heat for the power semiconductor device of the photovoltaic inverter.

The two substrates are spaced from each other in the third direction, and projections of the two substrates in the third direction do not overlap. In other words, the middle separator separates the cavity of the upper box body into two sub-cavities arranged opposite to each other in the third direction. In this way, external air flows into the two sub-cavities that are arranged opposite to each other in the third direction through one air vent of the upper box body, takes away a part of heat of each condenser in a process of flowing in each separate sub-cavity, and flows out of each separate sub-cavity through the other air vent of the upper box body. In this way, the gaseous refrigerant in the condenser in the upper box body is cooled and condensed into a liquid refrigerant. Under action of gravity, each condenser in the upper box body flows back to the evaporator through a liquid pipeline in the two-phase pipeline, to dissipate heat for the power semiconductor device of the photovoltaic inverter.

In an implementation, the upper box body includes two side plates arranged opposite to each other in the first direction, the two substrates are respectively arranged opposite to the two side plates in the first direction, and a distance between one of the two substrates and one of the two side plates is equal to a distance between the other of the two substrates and the other of the two side plates. In this way, the two sub-cavities of the upper box body are centrally symmetric with respect to a center line of the third substrate in the third direction. When a size of the upper box body is fixed, high-density disposing of the separate sub-cavities of the upper box body is ensured.

In an implementation, there is one evaporator, and a distance between one of the two condensers and one side plate is less than a distance between the other condenser and the one side plate.

Flow resistance of gas is related to a height. Therefore, when the two sub-cavities are distributed in the first direction, a height of a condenser located in the upper sub-cavity is set to be higher than a height of a condenser located in the lower sub-cavity. In this way, the one-to-two heat sink can avoid uneven amounts of gaseous refrigerants entering the two condensers from the evaporator due to a height difference between the two sub-cavities, thereby avoiding uneven distribution of heat that needs to be dissipated by the two condensers.

In an implementation, the upper box body includes two other side plates arranged opposite to each other in the third direction, the two substrates are respectively arranged opposite to the two other side plates in the third direction, and a distance between one of the two substrates and one of the two other side plates is equal to a distance between the other of the two substrates and the other of the two other side plates. In this way, the two sub-cavities of the upper box body are centrally symmetric with respect to the center line of the third substrate in the first direction. When sizes of the upper box body in the first direction, the third direction, and the second direction are fixed, high-density disposing of the separate sub-cavities of the upper box body is ensured.

In an implementation, the photovoltaic inverter further includes two groups of fans, each group of fans includes at least one fan, an air intake vent of each fan faces one air vent, and an air exhaust vent of each group of fans faces one condenser. In this way, each sub-cavity forms an air duct, and the gaseous refrigerant in the condenser in each sub-cavity is cooled through airflow flowing in each sub-cavity.

In an implementation, a distance between each fan and one air vent is less than a distance between each fan and the other air vent, and distances between the one air vent and fans are equal. In this way, each fan is uniformly disposed close to one of the two air vents, so that air in the cavity of the upper box body flows from one air vent to the other air vent. This simplifies an assembly process of the fan.

In an implementation, a projection of each fan in each sub-cavity in the second direction overlaps a projection of a condenser in each sub-cavity. In this way, air on an air exhaust vent side of each group of fans can quickly cool the gaseous refrigerant in the condenser, thereby improving cooling efficiency of the gaseous refrigerant in the condenser.

In an implementation, there are two evaporators, and each evaporator is configured to be connected to one condenser through a two-phase pipeline. In other words, the evaporator and the condenser in the heat sink are disposed in a one-to-one manner. In this way, an assembly process between the evaporator and the condenser is simple, and costs are low.

According to a second aspect, a photovoltaic power generation system is provided, including a photovoltaic module and the photovoltaic inverter according to any one of the first aspect and the possible implementations of the first aspect. The photovoltaic module is configured to convert light energy into electric energy, and the photovoltaic inverter is configured to convert a direct current from the photovoltaic module into an alternating current.

For technical effect of the second aspect, refer to the corresponding descriptions of the first aspect. Details are not described herein again.

### BRIEF DESCRIPTION OF DRAWINGS

FIG. 1 is a diagram of an example of a photovoltaic power generation system according to an embodiment of this application;
FIG. 2 is a diagram of a three-dimensional structure of an example of a photovoltaic inverter according to an embodiment of this application;
FIG. 3 is a diagram of a two-dimensional structure of the photovoltaic inverter shown in FIG. 2;
FIG. 4 is a diagram of a three-dimensional structure of another example of a photovoltaic inverter according to an embodiment of this application;
FIG. 5 is a diagram of a two-dimensional structure of the photovoltaic inverter shown in FIG. 4;
FIG. 6 is a diagram of a three-dimensional structure of still another example of a photovoltaic inverter according to an embodiment of this application;
FIG. 7 is a diagram of a two-dimensional structure of the photovoltaic inverter shown in FIG. 6;
FIG. 8 is a diagram of a three-dimensional structure of yet another example of a photovoltaic inverter according to an embodiment of this application;
FIG. 9 is a diagram of a two-dimensional structure of the photovoltaic inverter shown in FIG. 8;
FIG. 10 is a diagram of a three-dimensional structure of still yet another example of a photovoltaic inverter according to an embodiment of this application;
FIG. 11 is a diagram of a two-dimensional structure of the photovoltaic inverter shown in FIG. 10;
FIG. 12 is a diagram of a three-dimensional structure of a further example of a photovoltaic inverter according to an embodiment of this application;
FIG. 13 is a diagram of a two-dimensional structure of the photovoltaic inverter shown in FIG. 12;
FIG. 14 is a diagram of a three-dimensional structure of a still further example of a photovoltaic inverter according to an embodiment of this application;
FIG. 15 is a diagram of a two-dimensional structure of the photovoltaic inverter shown in FIG. 14;
FIG. 16 is a diagram of a three-dimensional structure of a yet further example of a photovoltaic inverter according to an embodiment of this application;
FIG. 17 is a diagram of a two-dimensional structure of the photovoltaic inverter shown in FIG. 16;
FIG. 18 is a diagram of a three-dimensional structure of a still yet further example of a photovoltaic inverter according to an embodiment of this application;
FIG. 19 is a diagram of a two-dimensional structure of the photovoltaic inverter shown in FIG. 18;
FIG. 20 is a diagram of a three-dimensional structure of even yet another example of a photovoltaic inverter according to an embodiment of this application;
FIG. 21 is a diagram of a two-dimensional structure of the photovoltaic inverter shown in FIG. 20; and
FIG. 22 is a diagram of a three-dimensional structure of an example of a photovoltaic inverter integrated installation container according to an embodiment of this application.

### DESCRIPTION OF EMBODIMENTS

The following describes technical solutions of embodiments in this application with reference to accompanying drawings.

In descriptions of embodiments of this application, "/" indicates "or" unless otherwise specified. For example, A/B may indicate A or B. In this specification, "and/or" describes only an association relationship between associated objects and indicates that three relationships may exist. For example, A and/or B may indicate the following three cases: Only A exists, both A and B exist, and only B exists.

In embodiments of this application, prefix words such as "first", "second", "third", and the like are merely used to distinguish between different described objects, and do not limit a location, a sequence, a priority, a quantity, content, or the like of the described object. Use of prefix words such as ordinal numbers used to distinguish the described objects in embodiments of this application does not constitute a limitation on the described objects. For descriptions of the described objects, refer to the context description in claims or embodiments, and the use of such prefix words should not constitute a redundant limitation. In addition, in the descriptions of embodiments, unless otherwise specified, "a plurality of" means two or more.

In embodiments of this application, orientation or position relationships indicated by terms such as "upper", "lower", "left", "right", "front", "rear", "top", "bottom", "inside", "outside", or the like are orientation or position relationships shown in the accompanying drawings, and are merely intended for ease of describing this application and simplifying descriptions, but are not intended to indicate or imply that an indicated apparatus or element needs to have a specific orientation or needs to be constructed and operated in a specific orientation. Therefore, this cannot be understood as a limitation on this application.

Reference to "some embodiments" or the like described in this specification indicates that one or more embodiments of this application include a specific feature, structure, or characteristic described with reference to embodiments. Therefore, statements such as "in some embodiments" that appear at different places in this specification do not necessarily mean reference to a same embodiment. Instead, the statements mean "one or more but not all of embodiments", unless otherwise specifically emphasized in another manner. Terms "include", "contain", "have", and their variants all mean "include but are not limited to", unless otherwise specifically emphasized in another manner.

In this application, "perpendicular" is not strictly perpendicular, but within an allowable error range. "Parallel" is not strictly parallel, but within an allowable error range.

In embodiments of this application, a same reference numeral indicates a same component part or a same part or component. In embodiments of this application, for a plurality of same parts or components, only one part or component may be marked with a reference numeral as an example in the accompanying drawings. For another same part or component, the reference numeral is also applicable. In addition, dimensions and sizes of parts or components shown in the accompanying drawings are merely examples.

An embodiment of this application provides a photovoltaic inverter. The photovoltaic inverter includes at least one power semiconductor device, a heat sink, an upper box body, and a lower box body. The lower box body is configured to accommodate the at least one power semiconductor device. The heat sink includes two condensers and at least one evaporator. The evaporator is configured to: be connected to the condenser through a two-phase pipeline, be in contact with and connected to an outer wall of the lower box body, and be connected to the power semiconductor device in a thermally conductive manner. The upper box body and the lower box body are arranged in a first direction. The upper box body includes a middle separator and two air vents arranged opposite to each other in a second direction. The middle separator is in a stepped structure in the second direction. The middle separator is configured to separate a cavity of the upper box body into two sub-cavities, each sub-cavity is configured to accommodate one condenser, and the two condensers are spaced from each other in the second direction.

According to the photovoltaic inverter provided in this embodiment of this application, a refrigerant in the evaporator can absorb heat generated by the power semiconductor device in the lower box body and is evaporated into a gaseous refrigerant, and the gaseous refrigerant may enter each condenser in the upper box body through a gas pipeline in the two-phase pipeline connected to each condenser. External air flows into each separate sub-cavity of the upper box body through one air vent of the upper box body, takes away a part of heat of each condenser in a process of flowing in each separate sub-cavity, and flows out of each separate sub-cavity through the other air vent of the upper box body. In this way, the gaseous refrigerant in the condenser in the upper box body is cooled and condensed into a liquid refrigerant. Under action of gravity, each condenser in the upper box body flows back to the evaporator through a liquid pipeline in the two-phase pipeline, to dissipate heat for the power semiconductor device of the photovoltaic inverter.

Because the condenser and the evaporator are disposed in the first direction, the refrigerant in the evaporator can be vaporized and then enter the condenser without being driven by a pump or another power device, and the refrigerant condensed into a liquid state by the condenser flows back to the evaporator under the action of gravity. In this way, efficient circulation of the refrigerant between the evaporator and the evaporator is implemented. In addition, because the middle separator is of the stepped structure in the second direction, each separate sub-cavity in the upper box body is also of a stepped structure in the second direction. In addition, each condenser is disposed in a separate sub-cavity, and the two condensers are spaced from each other in the second direction. In this way, not only heat dissipated by each sub-cavity does not affect each other, but also a thermal cascading phenomenon can be avoided. In addition, when a size of the upper box body is fixed, sufficient condensation area is ensured. Further, heat dissipation effect of the photovoltaic inverter is improved, and a service life of the photovoltaic inverter is prolonged.

In addition, on a premise that the size of the upper box body is fixed, the middle separator of the stepped structure is disposed in the upper box body, so that heat dissipated by each sub-cavity can be isolated, and a sufficient condensation area is ensured. This simplifies a processing process and an assembly process of the photovoltaic inverter, and reduces production costs of the photovoltaic inverter.

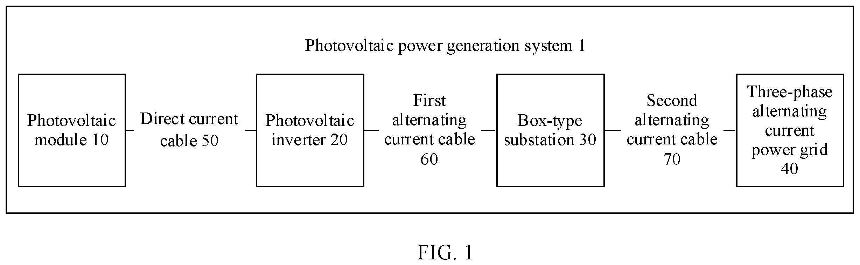

An embodiment of this application further provides a photovoltaic power generation system. The following first describes in detail the photovoltaic power generation system provided in this embodiment of this application with reference to FIG. 1.

FIG. 1 is a diagram of a photovoltaic power generation system according to an embodiment of this application. As shown in FIG. 1, a photovoltaic power generation system 1 provided in this embodiment of this application includes one or more photovoltaic modules 10, a photovoltaic inverter 20, a box-type substation 30, a three-phase alternating current power grid 40, a direct current cable 50, a first alternating current cable 60, and a second alternating current cable 70. The one or more photovoltaic modules 10 are connected to the photovoltaic inverter 20 through the direct current cable 50, and a connection relationship between the photovoltaic modules 10 and the photovoltaic inverter 20 may be a many-to-one connection. The photovoltaic inverter 20 converts a direct current into an alternating current, and an alternating current side of the photovoltaic inverter 20 is connected to the box-type substation 30 through the first alternating current cable 60. The box-type substation 30 is connected to the three-phase alternating current power grid 40 through the second alternating current cable 70. In this way, an alternating current output by the photovoltaic inverter 20 flows into the three-phase alternating current power grid 40 after passing through the box-type substation 30.

The photovoltaic power generation system 1 is a power generation system that converts solar radiation energy into electric energy through photovoltaic effect of a semiconductor material. The photovoltaic power generation system 1 provided in this embodiment of this application can supply power to an electric vehicle. The electric vehicle includes a pure electric vehicle, a hybrid electric vehicle, a range extended electric vehicle, a plug-in hybrid electric vehicle, a new energy vehicle, or the like. The pure electric vehicle is also referred to as a pure electric vehicle/battery electric vehicle, or referred to as a pure EV/battery EV for short. The hybrid electric vehicle is also referred to as a hybrid electric vehicle, or referred to as an HEV for short. The range extended electric vehicle is also referred to as a range extended electric vehicle, or referred to as an REEV for short. The plug-in hybrid electric vehicle is also referred to as a plug-in hybrid electric vehicle, or referred to as a PHEV for short. The new energy vehicle is also referred to as a new energy vehicle, or referred to as an NEV for short.

The photovoltaic module 10 may also be referred to as a photovoltaic array, and includes a plurality of photovoltaic strings. Photovoltaic is also referred to as photovoltaic, or referred to as PV for short. A string is also referred to as a string. Each photovoltaic string includes a plurality of photovoltaic panels connected in series. The photovoltaic panel is configured to convert light energy into electric energy. The electric energy generated by the photovoltaic panel is a DC. Voltages at two ends of the photovoltaic string are equal to a sum of voltages generated by the plurality of photovoltaic panels. Output power of the photovoltaic module may represent electric energy output by the photovoltaic module in a unit time.

In the photovoltaic power generation system 1, an area of each photovoltaic module 10 is usually fixed. When light intensity of light is unchanged, a larger included angle between light irradiated on the photovoltaic module 10 and a plane on which the photovoltaic module 10 is located, namely, a smaller incident angle of the light irradiated on the photovoltaic module 10, indicates more electric energy output by the photovoltaic module 10. When light is perpendicularly irradiated onto the photovoltaic module 10, that is, when the included angle between the light and the plane on which the photovoltaic module 10 is located is 90°, the included angle reaches a maximum value, and the output power of the photovoltaic module 10 reaches a maximum value.

The box-type substation 30 is briefly referred to as a box substation 30, and is a compact power distribution device that integrates a high-voltage switchgear, a power distribution transformer, and a low-voltage power distribution apparatus based on a specific cable connection scheme. For example, the box-type substation 30 integrates devices such as a low-voltage cabinet, a transformer, a ring main unit, and an auxiliary power supply into a container, to provide a highly integrated power transformation and distribution solution for a medium-voltage grid-tied scenario of a ground photovoltaic power station.

When the photovoltaic power generation system 1 includes a plurality of photovoltaic modules 10, the photovoltaic power generation system 1 further includes a combiner box. The combiner box is configured to combine direct currents generated by the plurality of photovoltaic modules 10, and input a combined output to the photovoltaic inverter 20.

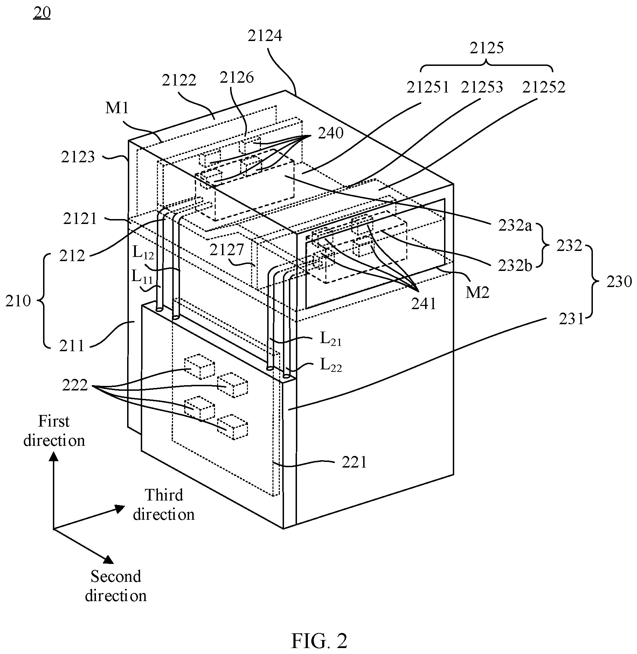

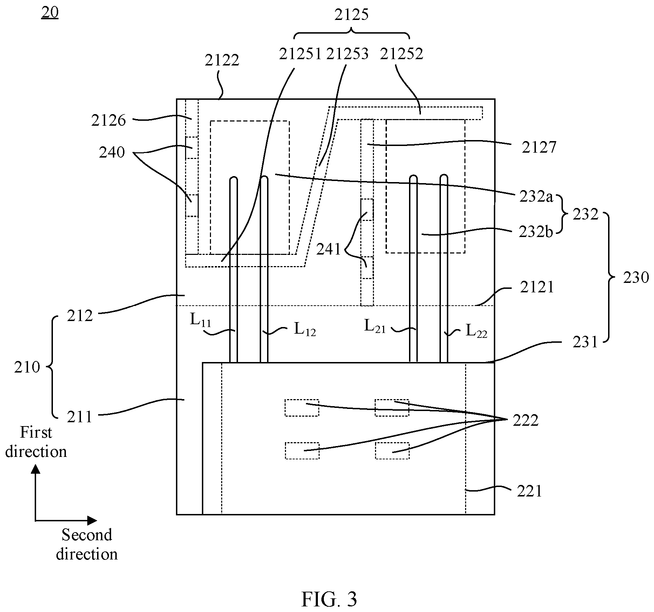

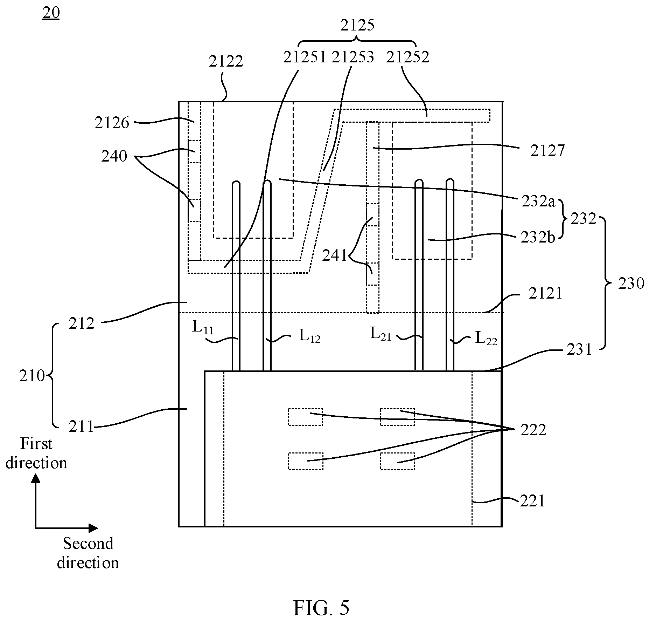

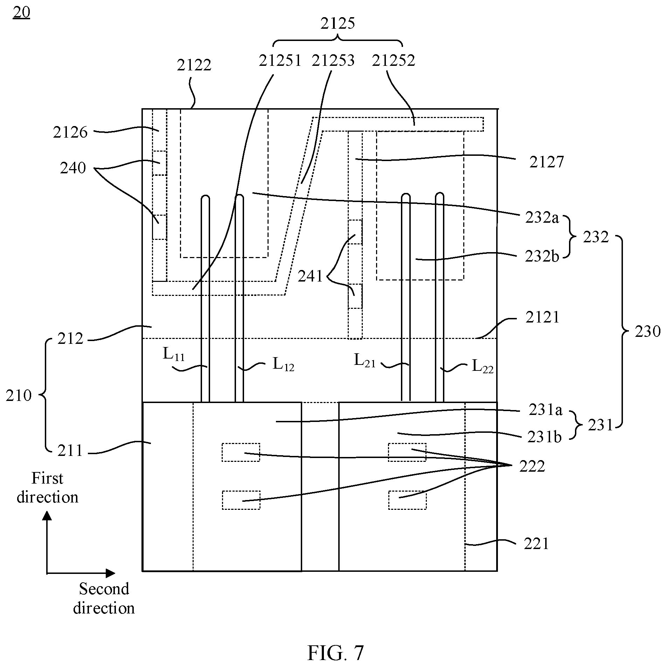

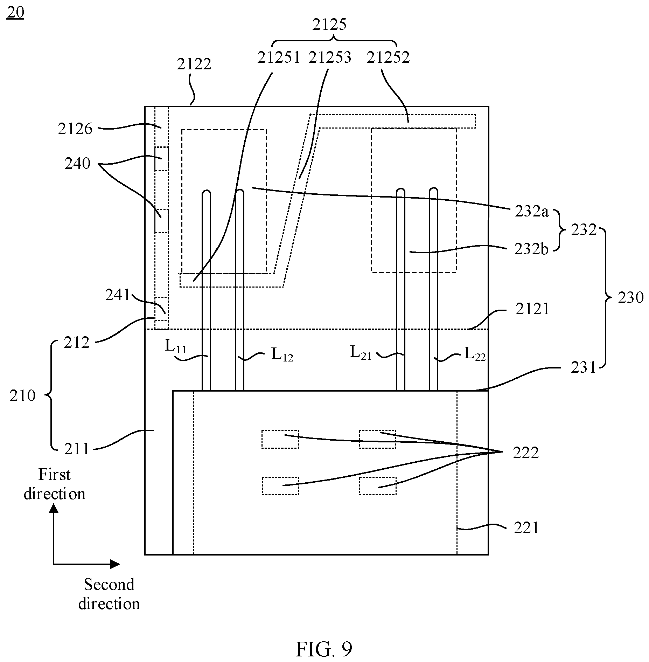

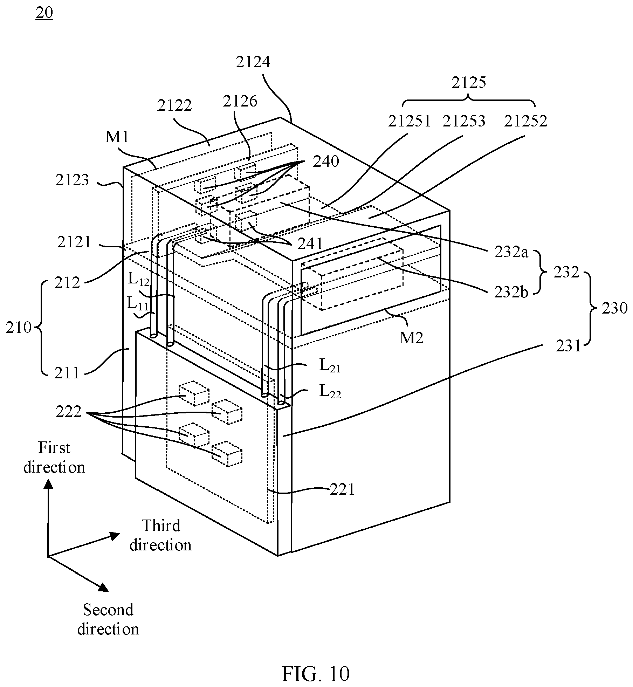

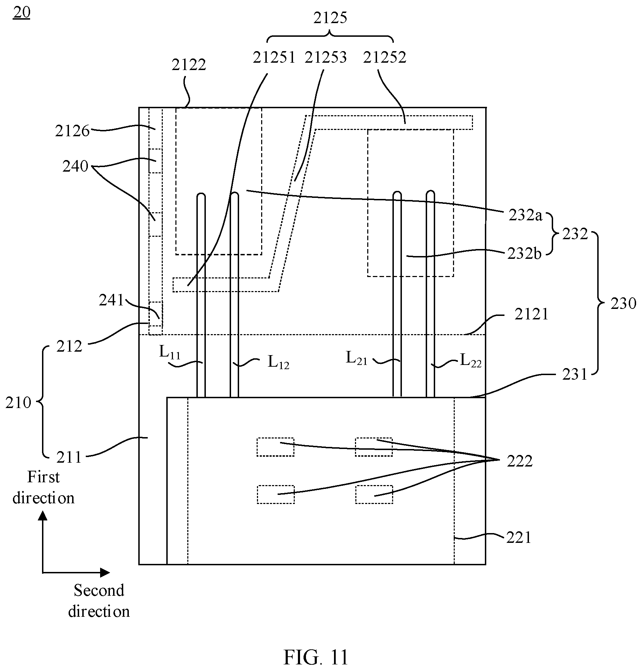

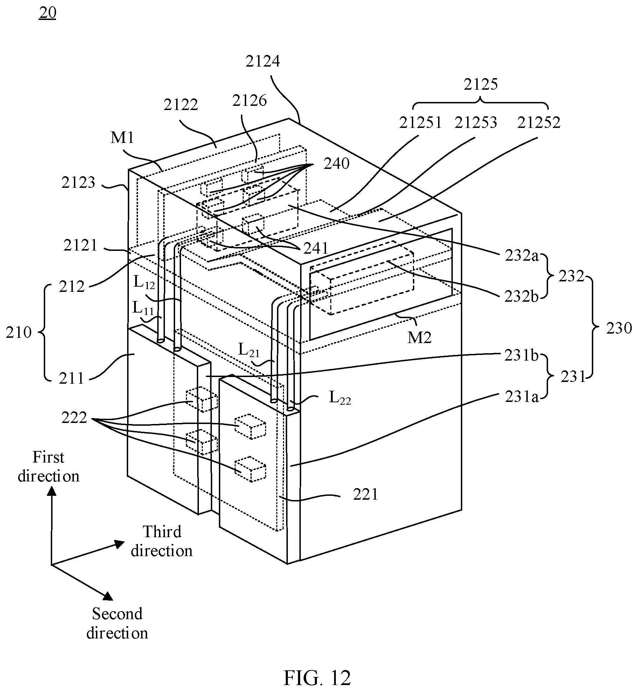

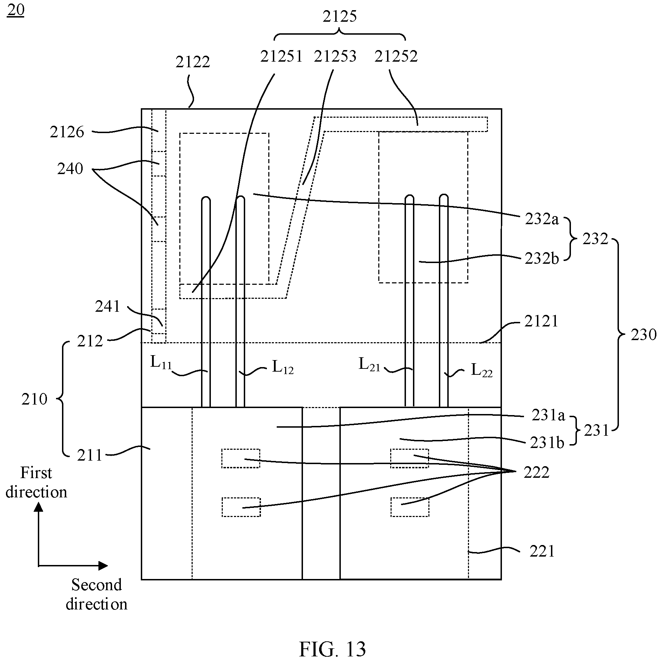

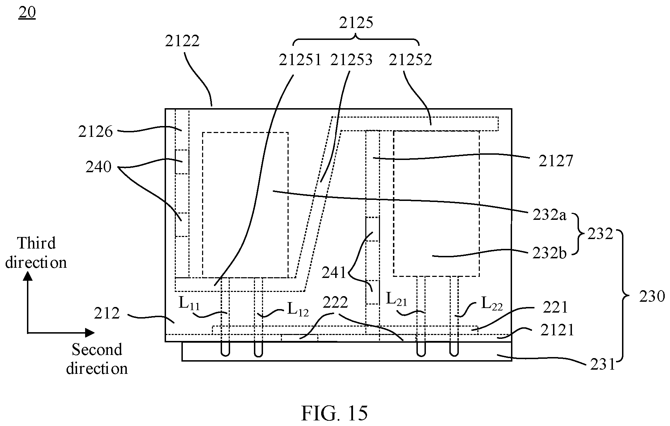

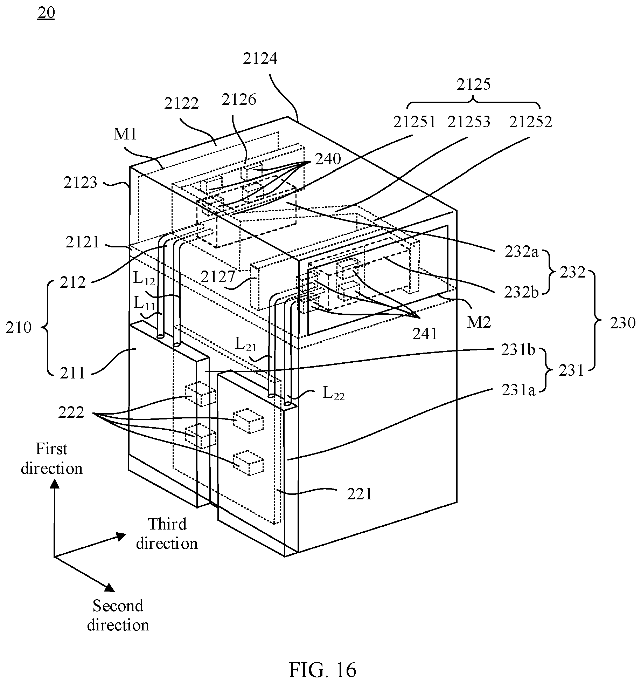

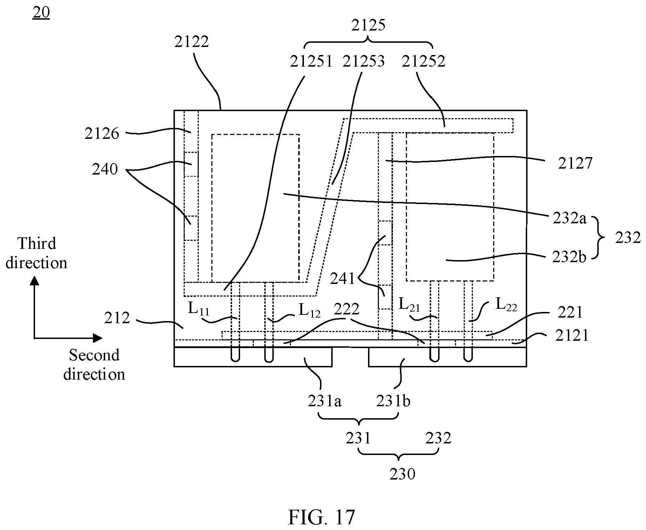

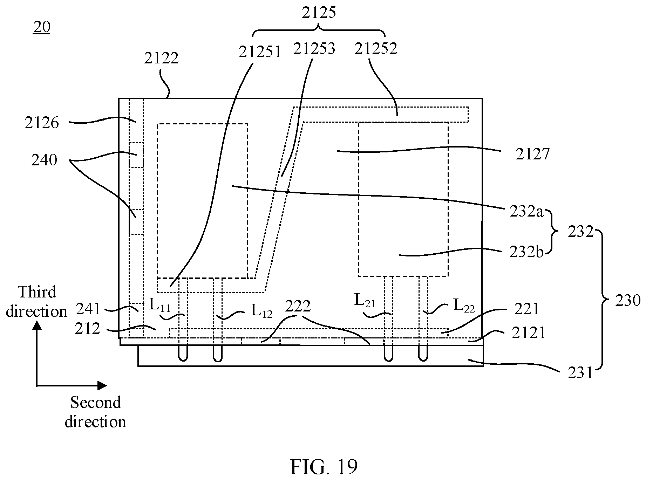

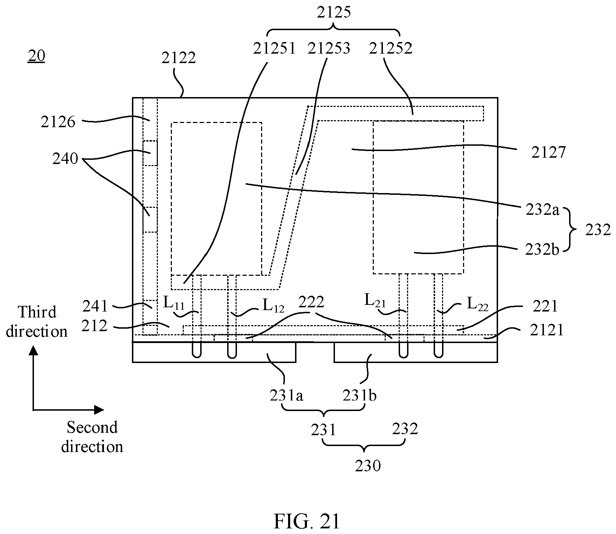

Each photovoltaic inverter 20 is configured to convert an input DC into an AC, that is, perform DC-AC conversion. The photovoltaic inverter 20 may also be referred to as a DC-AC converter. The following describes in detail a specific structure of the photovoltaic inverter 20 provided in this embodiment of this application with reference to FIG. 2 to FIG. 21.

As shown in FIG. 2 to FIG. 13, FIG. 14, FIG. 16, FIG. 18, and FIG. 20, a box body 210 of the photovoltaic inverter 20 includes a lower box body 211 and an upper box body 212 that are arranged opposite to each other in a first direction.

The lower box body 211 includes a top plate and a bottom plate that are arranged opposite to each other in the first direction, a left side plate and a right side plate that are arranged opposite to each other in a second direction, and a front plate and a rear plate that are arranged opposite to each other in a third direction. The top plate, the bottom plate, the front plate, the rear plate, the left side plate, and the right side plate are mutually enclosed to form an accommodation cavity of the lower box body 211.

In an embodiment, the first direction, the third direction, and the second direction are perpendicular to each other. It should be understood that the first direction may also be referred to as an up-down direction of the photovoltaic inverter 20 or a gravity direction of the photovoltaic inverter 20, the third direction may also be referred to as a front-back direction of the photovoltaic inverter 20, and the second direction may also be referred to as a left-right direction of the photovoltaic inverter 20.

As shown in FIG. 2, FIG. 4, FIG. 6, FIG. 8, FIG. 10, FIG. 12, FIG. 14, FIG. 16, FIG. 18, and FIG. 20, the upper box body 212 includes four side plates. Two of the four side plates are a lower side plate 2121 and an upper side plate 2122, and the other two side plates are a front side plate 2123 and a rear side plate 2124. The lower side plate 2121 and the upper side plate 2122 are arranged opposite to each other in the first direction, and the front side plate 2123 and the rear side plate 2124 are arranged opposite to each other in the third direction. The lower side plate 2121, the upper side plate 2122, the front side plate 2123, and the rear side plate 2124 form a cavity by enclosing each other. The cavity of the upper box body 212 includes two air vents arranged opposite to each other in the second direction, and the two air vents are one air vent M1 and the other air vent M2.

In an embodiment, to prevent a component accommodated in the accommodation cavity of the lower box body 211 from being affected by an environment and thereby reducing a service life of the component, the accommodation cavity of the lower box body 211 is usually a closed cavity.

In an embodiment, to reduce production costs, the lower box body 211 and the upper box body 212 may share one wall. The top plate of the lower box body 211 and the lower side plate 2121 of the upper box body 212 are one plate. In this way, the top plate of the lower box body 211 or the lower side plate 2121 of the upper box body 212 separates the box body 210 into the accommodation cavity of the lower box body 211 and the accommodation cavity of the upper box body 212.

In another embodiment, to prevent heat in the upper box body 212 from flowing back to the lower box body 211, the lower box body 211 and the upper box body 212 do not share a wall. In this embodiment, the photovoltaic inverter 20 further includes a connecting piece, and the connecting piece is configured to be connected to the lower box body 211 and the upper box body 212. For example, the connecting piece includes a plurality of beams, a size of each beam in the first direction is equal to a distance between the lower box body 211 and the upper box body 212. Each beam is configured to support and be fastened to the top plate of the lower box body 211 and the lower side plate 2121 of the upper box body 212, and is configured to support the upper box body 212.

As shown in FIG. 2 to FIG. 21, the upper box body 212 further includes a middle separator 2125, the middle separator 2125 is in a stepped structure in the second direction, and the middle separator 2125 is configured to separate the cavity of the upper box body 212 into two sub-cavities.

In some embodiments, as shown in FIG. 2 to FIG. 21, the middle separator 2125 includes three substrates. Two of the three substrates are a first substrate 21251 and a second substrate 21252, and another substrate is a third substrate 21253.

In an embodiment, as shown in FIG. 2 to FIG. 13, in the first direction, the first substrate 21251 and the second substrate 21252 are spaced from each other, and projections of the first substrate 21251 and the second substrate 21252 do not overlap. The third substrate 21253 is configured to be connected to the first substrate 21251 and the second substrate 21252. In this way, the middle separator 2125 separates the cavity of the upper box body 212 into two sub-cavities that are arranged opposite to each other in the first direction. In other words, the two sub-cavities of the upper box body 212 are distributed in an up-down direction.

Further, in an embodiment, the first substrate 21251 and the second substrate 21252 are respectively arranged opposite to the lower side plate 2121 and the upper side plate 2122 in the first direction. A distance between the first substrate 21251 and the upper side plate 2122 is equal to a distance between the second substrate 21252 and the lower side plate 2121, or a distance between the first substrate 21251 and the lower side plate 2121 is equal to a distance between the second substrate 21252 and the upper side plate 2122. In this way, the two sub-cavities of the upper box body 212 are centrally symmetric with respect to a center line of the third substrate 21253 in the third direction. When sizes of the upper box body 212 in the first direction, the third direction, and the second direction are fixed, high-density disposing of the separate sub-cavities of the upper box body 212 is ensured.

Further, in an embodiment, at least one of two opposite side surfaces of the middle separator 2125 in the third direction is fastened to an inner wall of the upper box body 212. In another embodiment, the photovoltaic inverter 20 further includes a first fastening plate 2126. The first fastening plate 2126 is arranged between the first substrate 21251 and the upper side plate 2122 in the first direction, and the first fastening plate 2126 is separately fastened to the first substrate 21251 and the upper side plate 2122. In addition, the photovoltaic inverter 20 further includes a second fastening plate 2127. The second fastening plate 2127 is arranged between the second substrate 21252 and the lower side plate 2121 in the first direction, and the second fastening plate 2127 is separately fastened to the second substrate 21252 and the lower side plate 2121.

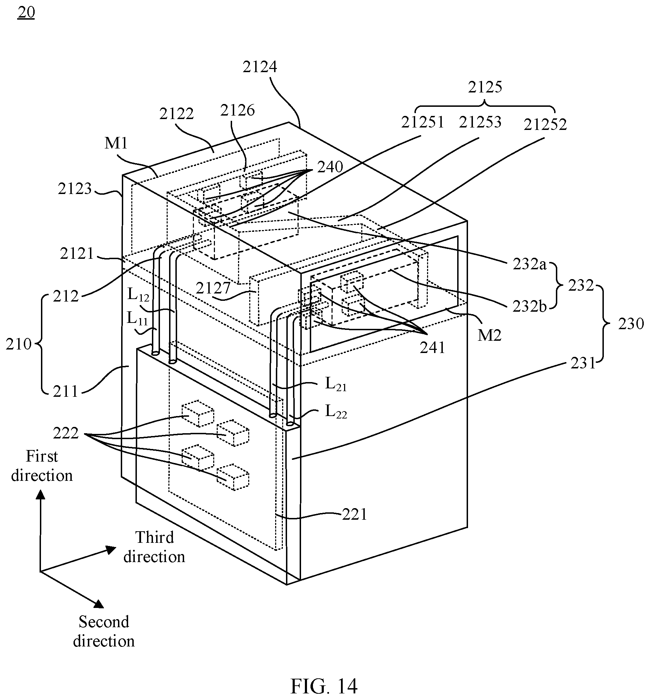

In another embodiment, as shown in FIG. 14 to FIG. 21, in the third direction, the first substrate 21251 and the second substrate 21252 are spaced from each other, and projections of the first substrate 21251 and the second substrate 21252 do not overlap. The third substrate 21253 is configured to be connected to the first substrate 21251 and the second substrate 21252. In this way, the middle separator 2125 separates the cavity of the upper box body 212 into two sub-cavities that are arranged opposite to each other in the third direction. In other words, the two sub-cavities of the upper box body 212 are distributed in a front-rear direction.

Further, in an embodiment, the first substrate 21251 and the second substrate 21252 are respectively arranged opposite to the front side plate 2123 and the rear side plate 2124 in the first direction. A distance between the first substrate 21251 and the front side plate 2123 is equal to a distance between the second substrate 21252 and the rear side plate 2124, or a distance between the first substrate 21251 and the rear side plate 2124 is equal to a distance between the second substrate 21252 and the front side plate 2123. In this way, the two sub-cavities of the upper box body 212 are centrally symmetric with respect to the center line of the third substrate 21253 in the first direction. When sizes of the upper box body 212 in the first direction, the third direction, and the second direction are fixed, high-density disposing of the separate sub-cavities of the upper box body 212 is ensured.

Further, in an embodiment, at least one of two opposite side surfaces of the middle separator 2125 in the first direction is fastened to the inner wall of the upper box body 212. In another embodiment, the photovoltaic inverter 20 further includes a first fastening plate 2126. The first fastening plate 2126 is arranged between the first substrate 21251 and the rear side plate 2124 in the third direction, and the first fastening plate 2126 is separately fastened to the first substrate 21251 and the rear side plate 2124. In addition, the photovoltaic inverter 20 further includes a second fastening plate 2127. The second fastening plate 2127 is arranged between the second substrate 21252 and the front side plate 2123 in the third direction, and the second fastening plate 2127 is separately fastened to the second substrate 21252 and the front side plate 2123.

In some embodiments, the three substrates of the middle separator 2125 are processed through integrated molding. This simplifies a processing process of the middle separator 2125, and reduces production costs of the middle separator 2125.

In some embodiments, an included angle between the third substrate 21253 and the first substrate 21251 and an included angle between the third substrate 21253 and the second substrate 21252 are between 90° and 180°. In this way, external air can easily flow out of each separate sub-cavity through the other air vent.

In some embodiments, as shown in FIG. 2 to FIG. 21, the photovoltaic inverter 20 further includes a circuit board 221 and at least one power semiconductor device 222. The circuit board 221 is configured to fasten each power semiconductor device 222.

The circuit board 221 is accommodated in the accommodation cavity of the lower box body 211, and the circuit board 221 is arranged opposite to any side plate of the lower box body 211. For ease of description, this application is described by using an example in which the circuit board 221 and the front plate of the lower box body 211 are arranged opposite to each other in the third direction shown in FIG. 2 to FIG. 21.

In this embodiment of this application, the circuit board 221 may also be referred to as a printed circuit board set. The printed circuit board set is also referred to as a printed circuit board assembly, or a PCBA for short.

For example, the power semiconductor device is an insulated gate bipolar transistor or a power inductor. The insulated gate bipolar transistor is also referred to as an insulated gate bipolar transistor, or is referred to as an IGBT for short. For example, the power semiconductor device in embodiments of this application may alternatively be another device with heat consumption.

In some embodiments, as shown in FIG. 2 to FIG. 21, the photovoltaic inverter 20 further includes a heat sink 230, and the heat sink 230 is configured to dissipate heat for each power semiconductor device.

In some embodiments, the heat sink 230 includes an evaporator 231 and a condenser 232. The evaporator 231 is configured to: be connected to the condenser 232 through a two-phase pipeline, and be in contact with and connected to an outer wall of the lower box body 211. The condenser 232 is accommodated in the accommodation cavity of the upper box body 212. Because the condenser 232 and the evaporator 231 are disposed in the first direction (or the gravity direction), a refrigerant in the evaporator 231 can be vaporized and then enter the condenser 232 without being driven by a pump or another power device, and the refrigerant condensed into a liquid state by the condenser 232 flows back to the evaporator 231 under action of gravity. In this way, efficient circulation of the refrigerant between the evaporator 231 and the evaporator 231 is implemented.

In an embodiment, the heat sink 230 includes one evaporator and two condensers. The evaporator is configured to: be connected to each condenser through a two-phase pipeline, and be in contact with and connected to the outer wall of the lower box body 211. Each condenser is accommodated in one sub-cavity of the upper box body 212. In this embodiment, the heat sink 230 may be referred to as a one-to-two heat sink 230. In this way, all power semiconductor devices share one evaporator, and heat dissipation capabilities of the two condensers can be shared, thereby reducing costs of the heat sink 230.

For example, as shown in FIG. 2 to FIG. 5, FIG. 8 to FIG. 11, FIG. 14, FIG. 15, FIG. 18, and FIG. 19, the heat sink 230 includes the evaporator 231, a first condenser 232a, and a second condenser 232b. The evaporator 231 is connected to the first condenser 232a through a first gas pipeline L₁₁ and a first liquid pipeline L₁₂, and is connected to the second condenser 232b through a second gas pipeline L₂₁ and a second liquid pipeline L₂₂. In this way, a refrigerant in the evaporator 231 can absorb heat generated by the power semiconductor device and is evaporated into a gaseous refrigerant, and the gaseous refrigerant enters the first condenser 232a through the first gas pipeline L₁₁, and enters the second condenser 232b through the second gas pipeline L₂₁. External air flows into each separate sub-cavity through the air vent M1, takes away a part of heat of the first condenser 232a and a part of heat of the second condenser 232b in a process of flowing in each separate sub-cavity, and flows out of each separate sub-cavity through the other air vent M2. In this way, the gaseous refrigerant in the first condenser 232a and the second condenser 232b is cooled and condensed into a liquid refrigerant. Under action of gravity, the first condenser 232a flows back to the evaporator 231 through the first liquid pipeline L₁₂, and the second condenser 232b flows back to the evaporator 231 through the second liquid pipeline L₂₂, to dissipate heat for the power semiconductor device of the photovoltaic inverter 20.

In another embodiment, the heat sink 230 includes two evaporators and two condensers. Each evaporator is configured to be connected to one condenser through a two-phase pipeline, and each evaporator is further configured to be in contact with and connected to the outer wall of the lower box body 211. Each condenser is accommodated in one sub-cavity of the upper box body 212. In this embodiment, the evaporators and the condensers in the heat sink 230 are disposed in a one-to-one manner. In this way, an assembly process between the evaporator and the condenser is simple, and costs are low.

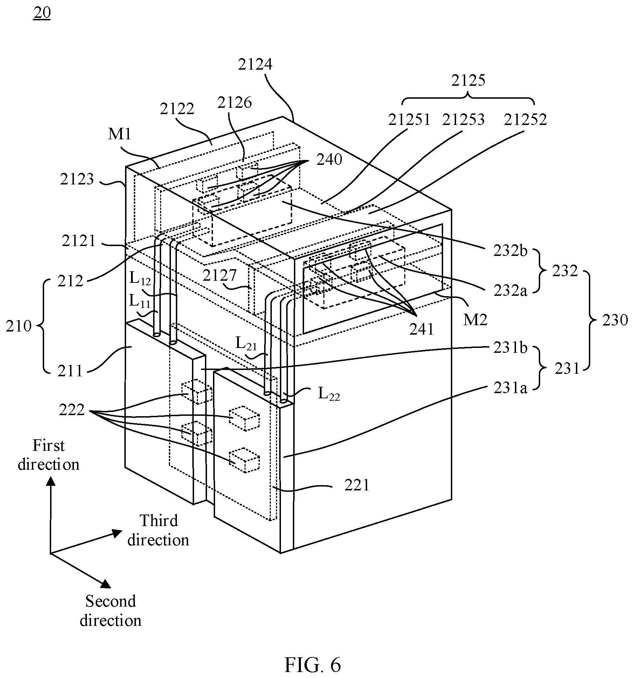

For example, as shown in FIG. 6, FIG. 7, FIG. 12, FIG. 13, FIG. 16, FIG. 17, FIG. 20, and FIG. 21, the heat sink 230 includes a first evaporator 231a, a second evaporator 231b, a first condenser 232a, and a second condenser 232b. The first evaporator 231a is connected to the first condenser 232a through a first gas pipeline L₁₁ and a first liquid pipeline L₁₂, and the second evaporator 231b is connected to the second condenser 232b through a second gas pipeline L₂₁ and a second liquid pipeline L₂₂. In this way, a refrigerant in each of the first evaporator 231a and the second evaporator 231b can absorb heat generated by the power semiconductor device and is evaporated into a gaseous refrigerant, the gaseous refrigerant in the first evaporator 231a enters the first condenser 232a through the first gas pipeline L₁₁, and the gaseous refrigerant in the second evaporator 231b enters the second condenser 232b through the second gas pipeline L₂₁. External air flows into each separate sub-cavity through the air vent M1, takes away a part of heat of the first condenser 232a and a part of heat of the second condenser 232b in a process of flowing in each separate sub-cavity, and flows out of each separate sub-cavity through the other air vent M2. In this way, the gaseous refrigerant in the first condenser 232a and the second condenser 232b is cooled and condensed into a liquid refrigerant. Under action of gravity, the first condenser 232a flows back to the first evaporator 231a through the first liquid pipeline L₁₂, and the second condenser 232b flows back to the second evaporator 231b through the second liquid pipeline L₂₂, to dissipate heat for the power semiconductor device of the photovoltaic inverter 20.

The evaporator 231 is connected to the power semiconductor device 222 in a thermally conductive manner. For example, at least one through hole is disposed on the front plate of the lower box body 211, each through hole penetrates the front plate in the third direction in which the front plate and the circuit board 221 are arranged, and each through hole is configured to accommodate one power semiconductor device 222. In addition, the evaporator 231 is in contact with and connected to an outer wall of the front plate of the lower box body 211. In this way, heat generated by the power semiconductor device 222 may be directly transferred to the evaporator 231, to reduce a heat conduction path from the power semiconductor device 222 to the evaporator 231. Therefore, heat conduction efficiency from the power semiconductor device 222 to the evaporator 231 is improved.

Further, in some embodiments, in the third direction, a projection of each through hole on the front plate is located in a projection of the evaporator 231. In addition, sealing elements are disposed around an area in which the evaporator 231 is in contact with the outer wall of the front plate. In this way, the lower box body 211 has high sealing performance.

The two condensers are spaced from each other in the second direction. For example, as shown in FIG. 2 to FIG. 21, the first condenser 232a and the second condenser 232b are spaced from each other in the second direction.

In some embodiments, the condensers have a same specification.

In an embodiment, in an arrangement direction of the two substrates, a size of each condenser is equal to a maximum size of a sub-cavity where the condenser is accommodated. In this way, each condenser can be fastened without disposing a fastener in each sub-cavity. This reduces production costs of the photovoltaic inverter 20.

For example, if the two substrates are spaced from each other in the first direction, a size of the first condenser 232a in the first direction is equal to the distance between the first substrate 21251 and the upper side plate 2122, and a size of the second condenser 232b in the first direction is equal to the distance between the second substrate 21252 and the lower side plate 2121. For another example, if the two substrates are spaced from each other in the third direction, a size of the first condenser 232a in the third direction is equal to the distance between the first substrate 21251 and the rear side plate 2124, and a size of the second condenser 232b in the third direction is equal to the distance between the second substrate 21252 and the front side plate 2123.

In another embodiment, in an arrangement direction of the two substrates, a size of each condenser is less than a maximum size of a sub-cavity where the condenser is accommodated. The photovoltaic inverter 20 further includes two fasteners (or supports), and each fastener (or support) is configured to fasten one condenser to a corresponding sub-cavity. In this way, each condenser is fastened via the fastener (or the support), so that each condenser is not shaken in a corresponding sub-cavity.

For example, as shown in FIG. 2 to FIG. 12, a size of the first condenser 232a in the first direction is less than the distance between the first substrate 21251 and the upper side plate 2122, and a size of the second condenser 232b in the first direction is less than the distance between the second substrate 21252 and the lower side plate 2121. For another example, as shown in FIG. 14 to FIG. 20, a size of the first condenser 232a in the third direction is less than the distance between the first substrate 21251 and the rear side plate 2124, and a size of the second condenser 232b in the third direction is less than the distance between the second substrate 21252 and the front side plate 2123.

In some embodiments, in the arrangement direction of the two substrates, a projection of each substrate overlaps a projection of one condenser.

For example, as shown in FIG. 2 to FIG. 13, the first substrate 21251 and the second substrate 21252 are arranged in the first direction, a projection of the first substrate 21251 overlaps a projection of the first condenser 232a in the first direction, and a projection of the second substrate 21252 overlaps a projection of the second condenser 232b in the first direction. In other words, the first condenser 232a is located above the first substrate 21251 in the first direction, and the second condenser 232b is located below the second substrate 21252 in the first direction.

For another example, as shown in FIG. 14 to FIG. 21, the first substrate 21251 and the second substrate 21252 are arranged in the third direction, a projection of the first substrate 21251 overlaps a projection of the first condenser 232a in the third direction, and a projection of the second substrate 21252 overlaps a projection of the second condenser 232b in the third direction. In other words, the first condenser 232a is located behind the first substrate 21251 in the third direction, and the second condenser 232b is located in front of the second substrate 21252 in the first direction.

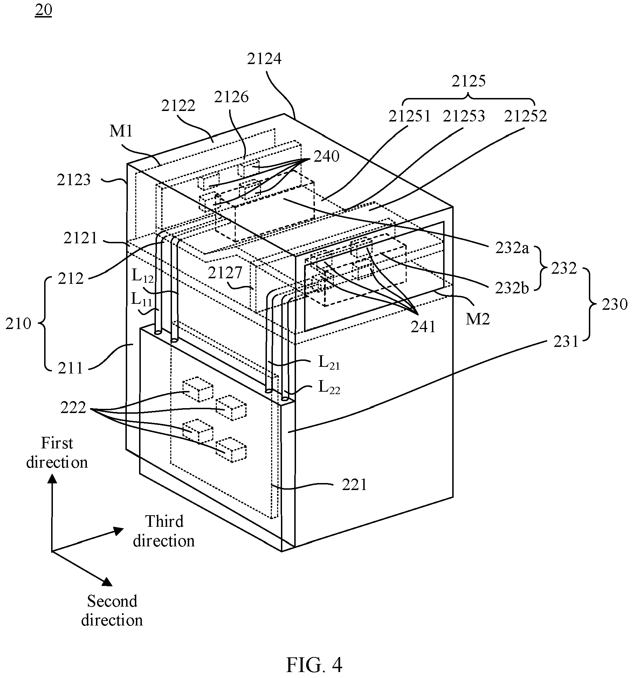

In some embodiments, as shown in FIG. 4, FIG. 5, FIG. 10, and FIG. 11, when the heat sink 230 includes one evaporator and two condensers, and the two substrates are spaced from each other in the first direction, a distance between the first condenser 232a of the two condensers and the upper side plate 2122 is less than a distance between the second condenser 232b and the upper side plate 2122. Flow resistance of gas is related to a height. Therefore, when the two sub-cavities are distributed in the first direction, a height of a condenser located in the upper sub-cavity is set to be higher than a height of a condenser located in the lower sub-cavity. In this way, the one-to-two heat sink 230 can avoid uneven amounts of gaseous refrigerants entering the two condensers from the evaporator due to a height difference between the two sub-cavities, thereby avoiding uneven distribution of heat that needs to be dissipated by the two condensers.

In some embodiments, the photovoltaic inverter 20 further includes a plurality of fans, and each fan is arranged between the lower side plate 2121 and the upper side plate 2122. In other words, each fan is located in the cavity of the upper box body 212. In this way, the fan can accelerate air circulation in the cavity of the upper box body 212.

The plurality of fans are divided into two groups, each group of fans includes at least one fan, an air intake vent of each fan faces one air vent, and an air exhaust vent of each group of fans faces one condenser.

In an embodiment, each group of fans is disposed in one sub-cavity, that is, each group of fans is configured to be accommodated in one sub-cavity. The fan and the condenser in each sub-cavity are sequentially arranged in the second direction. An air intake vent of each fan in each sub-cavity faces one air vent, and an air exhaust vent faces the other air vent. In this way, each sub-cavity forms an air duct, and the gaseous refrigerant in the condenser in each sub-cavity is cooled through airflow flowing in each sub-cavity.

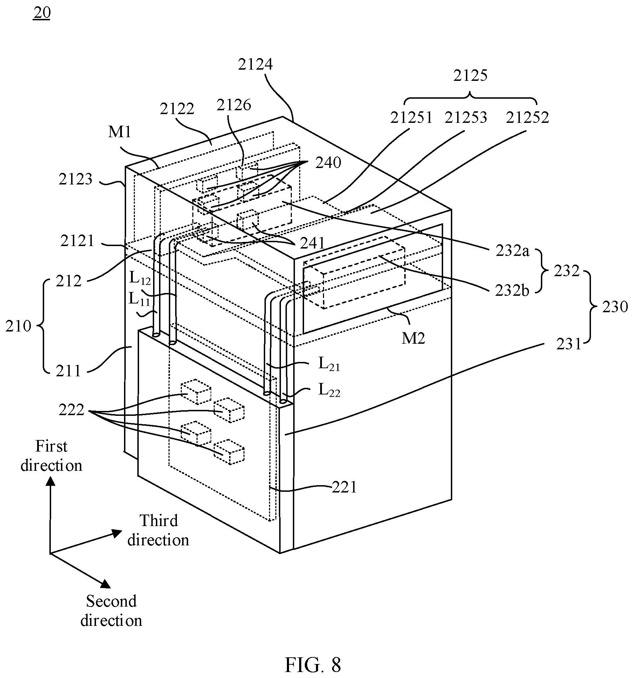

For example, as shown in FIG. 2 to FIG. 13, in the first direction, a first group of fans is accommodated in the upper sub-cavity. The first group of fans includes four fans 240, and the first group of fans and the first condenser 232a are sequentially arranged in the second direction. In addition, a second group of fans is accommodated in the lower sub-cavity. The second group of fans in FIG. 2 to FIG. 7 includes four fans 241, and the second group of fans in FIG. 8, FIG. 10, and FIG. 13 includes two fans 241. As shown in FIG. 2 to FIG. 13, the second group of fans and the second condenser 232b are sequentially arranged in the second direction. An air intake vent of each fan faces one air vent M1, and an air exhaust vent faces the other air vent M2.

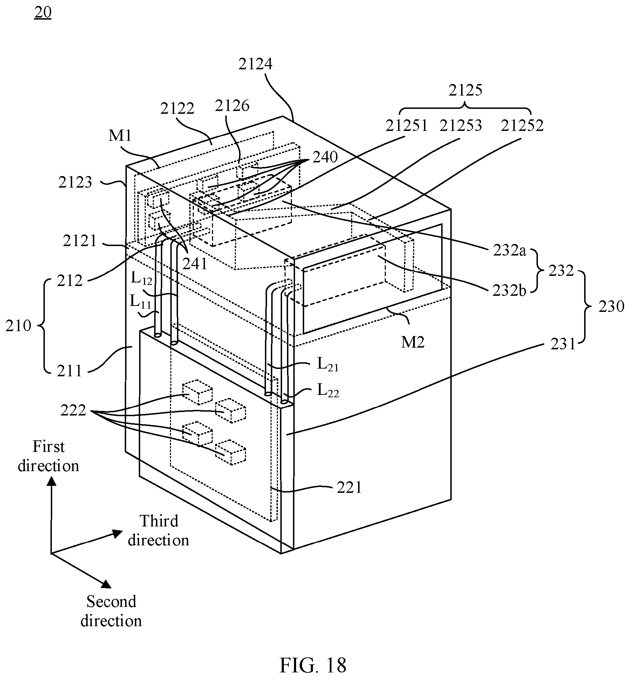

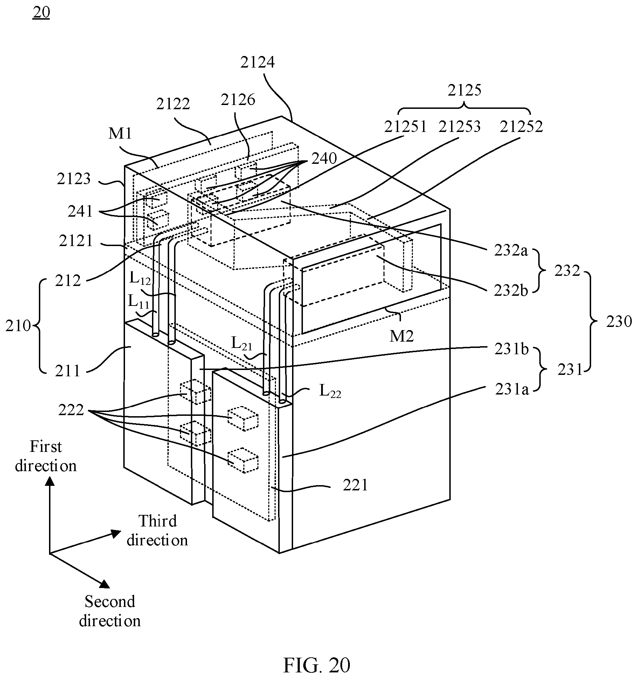

For another example, as shown in FIG. 14 to FIG. 21, in the third direction, a first group of fans is accommodated in the rear sub-cavity. The first group of fans includes four fans 240, and the first group of fans and the first condenser 232a are sequentially arranged in the second direction. In addition, a second group of fans is accommodated in the front sub-cavity. The second group of fans in FIG. 14 to FIG. 17 includes four fans 241, and the second group of fans in FIG. 18 and FIG. 20 includes two fans 241. As shown in FIG. 14 to FIG. 21, the second group of fans and the second condenser 232b are sequentially arranged in the second direction. An air intake vent of each fan faces one air vent M1, and an air exhaust vent faces the other air vent M2.

In another embodiment, the two groups of fans are uniformly disposed close to one air vent. For example, as shown in FIG. 8 to FIG. 13 and FIG. 18 to FIG. 21, a distance between each fan and the air vent M1 is less than a distance between each fan and the other air vent M2, and distances between the air vent M1 and fans are equal. In this way, each fan is uniformly disposed close to the air vent M1 of the two air vents, so that air in the cavity of the upper box body 212 flows from the air vent M1 to the other air vent M2. This simplifies an assembly process of the fan.

Further, in an example, each group of fans is fastened to one of two opposite side surfaces of the first substrate 21251 in the arrangement direction of the two substrates. For example, if the two substrates are spaced from each other in the first direction, the first group of fans is fastened to a side surface that is of the first substrate 21251 and that faces the upper side plate 2122, and the second group of fans is fastened to a side surface that is of the first substrate 21251 and that faces the lower side plate 2121. For another example, if the two substrates are spaced from each other in the third direction, the first group of fans is fastened to a side surface that is of the first substrate 21251 and that faces the rear side plate 2124, and the second group of fans is fastened to a side surface that is of the first substrate 21251 and that faces the front side plate 2123.

Further, in another example, one group of fans is fastened to a surface that is of the upper side plate 2122 and that faces the middle separator 2125, and the other group of fans is fastened to a surface that is of the lower side plate 2121 and that faces the middle separator 2125. For example, the first group of fans is fastened to a side surface that is of the upper side plate 2122 and that faces the middle separator 2125, and the second group of fans is fastened to a side surface that is of the lower side plate 2121 and that faces the middle separator 2125.

Further, in still another example, the two groups of fans are both fastened to the first fastening plate 2126. In this example, a size of the first fastening plate 2126 in the first direction is greater than a distance between the upper side plate 2122 and the first substrate 21251, and there is a spacing between the first fastening plate 2126 and the first substrate 21251 in the second direction.

In another embodiment, a distance between each group of fans and a condenser in a corresponding sub-cavity falls within a specific range. For example, as shown in FIG. 2 to FIG. 7 and FIG. 14 to FIG. 17, a distance between the first group of fans and the first condenser 232a falls within a specific range, and a distance between the second group of fans and the second condenser 232b falls within a specific range. In this way, air on an air exhaust vent side of each group of fans can diffuse in a corresponding sub-cavity, so that air in the corresponding sub-cavity is even, and air in each sub-cavity can evenly cool the gaseous refrigerant in the condenser. A distance range between each group of fans and the condenser in the corresponding sub-cavity may be set based on a historical empirical value.

Further, in an example, one group of fans is fastened to one of two opposite side surfaces of the first substrate 21251 in the arrangement direction of the two substrates, and the other group of fans is fastened to one of two opposite side surfaces of the second substrate 21252 in the arrangement direction of the two substrates. For example, if the two substrates are spaced from each other in the first direction, the first group of fans is fastened to a side surface that is of the first substrate 21251 and that faces the upper side plate 2122, and the second group of fans is fastened to a side surface that is of the second substrate 21252 and that faces the lower side plate 2121. For another example, if the two substrates are spaced from each other in the third direction, the first group of fans is fastened to a side surface that is of the first substrate 21251 and that faces the rear side plate 2124, and the second group of fans is fastened to a side surface that is of the second substrate 21252 and that faces the front side plate 2123.

Further, in another example, one group of fans is fastened to a surface that is of the upper side plate 2122 and that faces the middle separator 2125, and the other group of fans is fastened to a surface that is of the lower side plate 2121 and that faces the middle separator 2125. For example, the first group of fans is fastened to a side surface that is of the upper side plate 2122 and that faces the middle separator 2125, and the second group of fans is fastened to a side surface that is of the lower side plate 2121 and that faces the middle separator 2125.

Further, in still another example, one group of fans is fastened to the first fastening plate 2126, and the other group of fans is fastened to the second fastening plate 2127. In this example, a size of the first fastening plate 2126 in the first direction may be equal to a distance between the upper side plate 2122 and the first substrate 21251.

In some embodiments, a projection of each fan in each sub-cavity in the second direction overlaps a projection of a condenser in each sub-cavity. In this way, air on an air exhaust vent side of each group of fans can quickly cool the gaseous refrigerant in the condenser, thereby improving cooling efficiency of the gaseous refrigerant in the condenser.

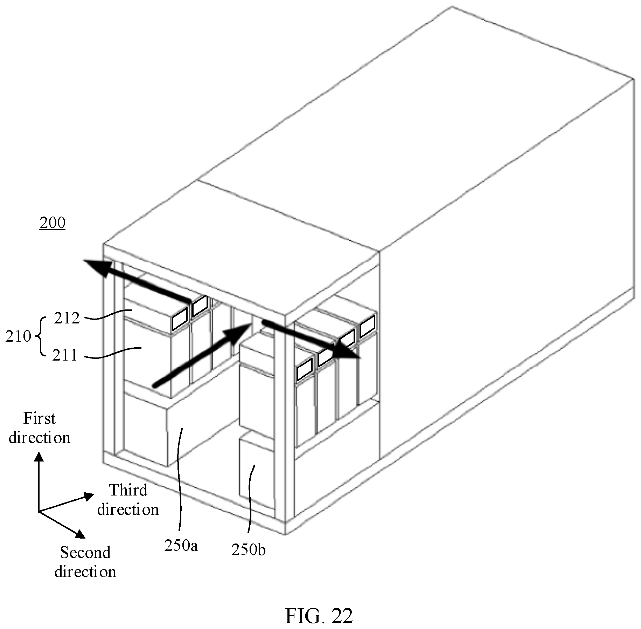

In some embodiments, to enable the photovoltaic power generation system to support direct current coupled energy storage and reduce costs of an alternating current cable, a plurality of photovoltaic inverters 20 may be integrated together and accommodated in a photovoltaic inverter integrated installation container. For example, as shown in FIG. 22, the plurality of photovoltaic inverters 20 of the photovoltaic inverter integrated installation container 200 are divided into two groups, and the two groups of photovoltaic inverters are spaced from each other in the second direction. Each group of photovoltaic inverters includes at least one photovoltaic inverter 20, and a plurality of photovoltaic inverters 20 in each group of photovoltaic inverters are arranged in the third direction. There is a spacing between each group of photovoltaic inverters and a top plate of the photovoltaic inverter integrated installation container 200. In this way, air that flows out of the upper box body 212 of each photovoltaic inverter 20 and that carries heat can be dissipated to the outside through the spacing between the upper box body 212 and the top plate of the photovoltaic inverter integrated installation container 200.

Further, in some embodiments, the photovoltaic inverter integrated installation container 200 further includes at least one power distribution cabinet, for example, a first power distribution cabinet 250a and a second power distribution cabinet 250b shown in FIG. 22. Each power distribution cabinet is accommodated in an accommodation cavity of the photovoltaic inverter integrated installation container 200, and each power distribution cabinet is configured to control each photovoltaic inverter, distribute power, and the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic inverter, wherein the photovoltaic inverter comprises:
at least one power semiconductor device;
a lower box body, configured to accommodate the power semiconductor device;
a heat sink, comprising two condensers and at least one evaporator, wherein the evaporator is configured to: be connected to the condenser through a two-phase pipeline, be in contact with and connected to an outer wall of the lower box body, and be connected to the power semiconductor device in a thermally conductive manner; and
an upper box body, wherein the upper box body and the lower box body are arranged in a first direction, the upper box body comprises a middle separator and two air vents arranged opposite to each other in a second direction, the middle separator is in a stepped structure in the second direction, the middle separator is configured to separate a cavity of the upper box body into two sub-cavities, each sub-cavity is configured to accommodate one condenser, and the two condensers are spaced from each other in the second direction.

2. The photovoltaic inverter according to claim 1, wherein the middle separator comprises three separators; two separators are spaced from each other in the first direction and projections of the two separators in the first direction do not overlap, or two separators are spaced from each other in a third direction and projections of the two separators in the third direction do not overlap; and another separator is configured to be connected to the two separators, wherein
in an arrangement direction of the two separators, a projection of each separator overlaps a projection of one condenser.

3. The photovoltaic inverter according to claim 2, wherein the upper box body comprises two side plates arranged opposite to each other in the first direction, the two separators are respectively arranged opposite to the two side plates in the first direction, and a distance between one separator of the two separators and one side plate of the two side plates is equal to a distance between the other separator of the two separators and the other side plate of the two side plates.

4. The photovoltaic inverter according to claim 3, wherein there is one evaporator, and a distance between one of the two condensers and the one side plate is less than a distance between the other condenser and the one side plate.

5. The photovoltaic inverter according to claim 2, wherein the upper box body comprises two other side plates arranged opposite to each other in the third direction, the two separators are respectively arranged opposite to the two other side plates in the third direction, and a distance between one of the two separators and one of the two other side plates is equal to a distance between the other of the two separators and the other of the two other side plates.

6. The photovoltaic inverter according to any one of claims 1 to 5, wherein the photovoltaic inverter further comprises two groups of fans, each group of fans comprises at least one fan, an air intake vent of each fan faces one air vent, and an air exhaust vent of each group of fans faces one condenser.

7. The photovoltaic inverter according to claim 6, wherein a distance between each fan and the one air vent is less than a distance between each fan and the other air vent; and
distances between the one air vent and fans are equal.

8. The photovoltaic inverter according to claim 6 or 7, wherein a projection of each fan in each sub-cavity overlaps a projection of the condenser in each sub-cavity in the second direction.

9. The photovoltaic inverter according to any one of claims 1 to 8, wherein there are two evaporators, and each evaporator is configured to be connected to one condenser through a two-phase pipeline.

10. A photovoltaic power generation system, comprising a photovoltaic module and the photovoltaic inverter according to any one of claims 1 to 9, wherein the photovoltaic module is configured to convert light energy into electric energy, and the photovoltaic inverter is configured to convert a direct current from the photovoltaic module into an alternating current.
